# EUROPÄISCHE PATENTSCHRIFT

(11) **EP 0 826 221 B1**
(45) Veröffentlichungstag und Bekanntmachung des Hinweises auf die Patenterteilung: **17.10.2001**
(21) Anmeldenummer: 97908209.6
(22) Anmeldetag: 10.03.1997
(51) Int. Cl.: G21K 5/10

(54) **ELEKTRONENSTRAHLANLAGE**
ELECTRON BOMBARDMENT INSTALLATION
INSTALLATION DE BOMBARDEMENT ELECTRONIQUE

(30) Priorität: 18.03.1996 DE 19610492
(43) Veröffentlichungstag der Anmeldung: 04.03.1998
(73) Patentinhaber: VIOTEC Gesellschaft für innovative Oberflächentechnik mbH, 26160 Bad Zwischenahn (DE)
(72) Erfinder: KAMPMEIER, Franz, D-33449 Langenberg (DE)
(74) Vertreter: von Hellfeld, Axel, Dr. Dipl.-Phys.
(86) Internationale Anmeldenummer: EP9701215
(87) Internationale Veröffentlichungsnummer: WO9735325

(56) Entgegenhaltungen:
- DE-A- 4 405 500
- DE-B- 1 764 592
- PATENT ABSTRACTS OF JAPAN vol. 004, no. 026 (C-001), 6.März 1980 & JP 55 001815 A (NIPPON BUNKA SEIKOU KK), 9.Januar 1980

## Beschreibung

Die Erfindung betrifft eine Elektronenstrahlanlage zum Aushärten von insbesondere Kunststoffschichten auf Werkstücken, mit einer Bestrahlungskammer, einem Elektronenstrahlerzeuger zum Erzeugen zumindest eines Elektronenstrahls in der Bestrahlungskammer, einer Transportvorrichtung zum Fördern der Werkstücke in die Bestrahlungskammer und aus der Bestrahlungskammer heraus, wobei vor und nach der Bestrahlungskammer jeweils zwei oder mehr Absperrvorrichtungen angeordnet sind, die in bezug auf die Transportvorrichtung bewegbar und so unter Abstand in Förderrichtung der Transportvorrichtung angeordnet sind, daß zumindest ein Werkstück zwischen zwei Absperrvorrichtungen paßt, und Abschirmungen, die die Transportvorrichtung vor und nach der Bestrahlungskammer von oben als Strahlungsschutz abdecken.

Eine vergleichbare Anlage ist aus PATENT ABSTRACTS OF JAPAN vol. 004, no. 026 (C-001), 6. März 1980 und JP 55 001815 A (NIPPON BUNKA SEIJOU KK), 9. Januar 1980. Dort ist die Anlage aber nicht für Elektronenbestrahlung vorgesehen, sondern für UV-Bestrahlung.

Eine Elektronenstrahlanlage ist aus der DE-A-20 04 050 bekannt. Dort sind direkt vor und nach der Bestrahlungskammer vertikal verschiebbare Absperrvorrichtungen vorgesehen, mit denen Öffnungen der Bestrahlungskammer, durch die die Werkstücke in die Bestrahlungskammer hineingeschoben bzw. aus dieser herausgeführt werden, gegen unerwünscht aus der Kammer austretende Strahlung abgeschirmt sind. Bei dieser Vorrichtung müssen die horizontal durch die Bestrahlungskammer laufenden Werkstücke in der Art eines "Stop-And-Go"-Verkehrs gefördert werden, d.h. es muß jeweils ein Werkstück in die Bestrahlungskammer eingeführt werden, und es muß dann die Bestrahlungskammer auf beiden Seiten geschlossen werden. Dabei ist die Transportvorrichtung kurzzeitig stillzusetzen. Nach erfolgter Bestrahlung des Werkstückes in der Bestrahlungskammer werden beide Absperrvorrichtungen auf der Einlaufseite und der Auslaufseite der Bestrahlungskammer geöffnet, damit das fertig bestrahlte Werkstück aus der Bestrahlungskammer entfernt und ein frisches Werkstück in die Bestrahlungskammer überführt werden können. Damit bei diesem Stand der Technik während des Öffnens der Absperrvorrichtung keine Streustrahlung (im wesentlichen durch die hochenergetischen Elektronen erzeugte Röntgenstrahlung) durch die Öffnungen aus der Bestrahlungskammer austreten kann, müssen aufwendige Mittel vorgesehen werden, um in diesen Öffnungszeiten der Bestrahlungskammer den Elektronenstrahl abzuschirmen.

Bei einer anderen bekannten Elektronenstrahlanlage (DE 44 06 887 C1) ist eine Bestrahlungskammer vorgesehen, die zum Zu- bzw. Abfördern plattenförmiger Werkstücke mit einer eine Zuführstrecke und eine Abführstrecke bildenden Transportvorrichtung zusammenwirkt, wobei diese zusätzlich zu einer Abschirmungshülle oberhalb ihrer Transportstrecke jeweils ein Fördermittel mit mehreren Schirmplatten als Horizontalabschirmung aufweist. Diese Schirmplatten können mit dem eine Umlaufbahn bildenden Fördermittel zur Abschirmung der im Bereich einer Durchtrittsöffnung aus der Bestrahlungskammer austretenden Streustrahlung kontinuierlich in ihre Abschirmstellung ein- bzw. aus dieser ausgeführen werden. Zur werkstücksynchronen Bewegung dieser schwergewichtigen Schirmplatten ist das Fördermittel mit einer technisch aufwendigen und bei einer Anpassung an veränderte Werkstückgrößen kompliziert handhabbaren Konstruktion versehen. Die gesamte Anlage ist mit der Abschirmungshülle im doppellagigen Bereich von Transportvorrichtung und Fördermittel überaus groß, und mit den vorbeschriebenen Baugruppen ist unterhalb der Abschirmungshülle ein innerer Hohlraum gebildet, der einen nachteilig hohen Verbrauch an Schutzgas verursacht. Außerdem ist die Zugänglichkeit der Anlage im Bereich der Bearbeitungsstrecke, beispielsweise zu Reparatur- und Wartungszwecken, durch eine aufwendige Demontage der Abschirmungshüllen erschwert.

Eine weitere bekannte Elektronenstrahlanlage (DE-A-17 64 592) beschreibt (Fig. 12) eine Fördervorrichtung für die zu bestrahlenden Werkstücke in Form eines Rundläufers mit abgetrennten Kammern. Der Rundläufer ist strahlungsdicht in einer sphärischen Ausnehmung nahe der Bestrahlungskammer geführt und die Werkstücke fallen nach der Bestrahlung auf ein Transportband. Diese Anlage eignet sich nur für relativ kleine Werkstücke, die geeignet sind, in einem Rundläufer gefördert zu werden. Eine andere Ausführungsform einer Elektronenstrahlanlage aus diesem Stand der Technik (Figuren 13, 14) beschreibt bleigefüllte Stahlrollen zur Abschirmung, deren Höhe verstellbar ist. Bei dieser Vorrichtung ist keine Höhenverstellbarkeit der Abschirmung zur Anpassung an unterschiedliche Werkstückhöhen vorgesehen. Auch sind dort die Absperrvorrichtungen nicht in den Förderweg der Werkstücke bewegbar.

Der Erfindung liegt die Aufgabe zugrunde, eine Elektronenstrahlanlage der eingangs genannten Art so weiterzubilden, daß bei geringem Bedienungsaufwand ein hoher Durchsatz der Anlage mit Werkstücken ermöglicht ist, daß die Anlage in einfacher Weise an unterschiedliche Werkstückabmessungen anpaßbar ist, daß eine sichere Abschirmung der Anlage gegen unerwünschte Strahlung gewährleistet ist und daß darüber hinaus auch eine Einsparung des Verbrauchs von Schutzgas ermöglicht ist.

Eine diese Aufgabe erfindungsgemäß lösende Elektronenstrahlanlage ist im Patentanspruch 1 gekennzeichnet.

Vorteilhafte Ausgestaltungen der Anlage sind in den abhängigen Ansprüchen beschrieben.

Mit einer solchen Elektronenstrahlanlage ist es möglich, die Bestrahlungskammer kontinuierlich mit zu bestrahlenden Werkstücken zu beschicken und bestrahlte Werkstücke aus der Kammer zu entfernen. Die erfindungsgemäße Elektronenstrahlanlage ermöglicht also einen kontinuierlichen Betrieb, sie kann jedoch auch in der Art eines "Stop-And-Go"-Betriebes gesteuert werden.

Bevorzugt sind insbesondere auf der Einlaufseite der Bestrahlungskammer (und gegebenenfalls auch spiegelsymmetrisch auf der Auslaufseite der Bestrahlungskammer) mehr als zwei Absperrvorrichtungen als Strahlungsschutz vorgesehen. Je nach Größe des Werkstückes können dann die Absperrvorrichtungen mittels einer elektronischen Steuerung so betätigt werden, daß bei Förderung einer Reihe von hintereinander mit Abstand auf der Transportvorrichtung angeordneten Werkstücken jeweils vor und hinter der Bestrahlungskammer mindestens ein Absperrorgan in eine Schließstellung zwischen zwei aufeinanderfolgenden Werkstücken bewegbar ist. Die Steuerung kann beispielsweise so durchgeführt werden, daß immer dann, wenn im Bereich einer Absperrvorrichtung kein Werkstück liegt, diese Absperrvorrichtung in ihre Schließstellung gebracht wird, in der sie das Austreten von Streustrahlung verhindert. Eine solche Steuerung ist beispielsweise vollautomatisch mit Lichtschranken, die das Vorhandensein oder die Annäherung eines Werkstückes im Bereich der Absperrvorrichtung ermitteln und entsprechende Daten an einen Rechner liefern, der mittels eines Motors die Absperrvorrichtungen steuert. Dadurch, daß in Förderrichtung der Transportvorrichtung zwei oder mehr Absperrvorrichtungen vorgesehen sind und weiterhin die Werkstücke von einer Beschickungsanlage mit einstellbarem gegenseitigem Abstand auf die Transportvorrichtung auflegbar sind, ist es möglich zu gewährleisten, daß während des Vorschubes der Werkstücke in die Bestrahlungskammer immer zumindest eine Absperrvorrichtung, bevorzugt sogar zwei oder mehr Absperrvorrichtungen, in ihrer Schließstellung sind, in der sie den unerwünschten Austritt von Strahlung aus dem Bereich der Elektronenstrahlanlage verhindern. Beschrieben wird auch ein Verfahren zum Steuern einer Elektronenstrahlanlage im vorstehend beschriebenen Sinn.

Die Erfindung sieht bevorzugt vor, daß die Transportvorrichtung eine horizontale, im wesentlichen ebene Transportbahn für die Werkstücke bereitstellt, und zwar sowohl vor als auch hinter der Bestrahlungskammer und besonders bevorzugt kontinuierlich auch in der Bestrahlungskammer, so daß die Werkstücke auf ihrem Weg in der Elektronenstrahlanlage vor, in und nach der Bestrahlungskammer auf einer geraden, horizontalen Bahn bewegt werden. Dies ermöglicht insbesondere eine unproblematische Förderung grosser (besonders großflächiger) Werkstücke.

Gemäß einer weiteren bevorzugten Ausgestaltung der Erfindung ist vorgesehen, daß der Elektronenstrahlerzeuger mittels eines ihn abstützenden Tragwerks aus der Bestrahlungskammer quer zur Förderrichtung der Transportvorrichtung in eine Stellung verschiebbar ist, in der der Elektronenstrahlerzeuger für Wartungs- und Reparaturarbeiten gut zugänglich ist.

Die Elektronenstrahlanlage mit den beschriebenen Absperrvorrichtungen hat einfach steuerbare Bauteile, insbesondere die bewegbaren Teile der Absperrvorrichtungen, die unterhalb oder oberhalb einer horizontalen Transportbahn der Transportvorrichtung abgestützt sind. Wie beschrieben, können bewegungssynchron zur Zuführung bzw. Abführung der Werkstücke zur Bestrahlungskammer bzw. aus der Bestrahlungskammer, die Durchlaßquerschnitte für die Werkstücke in Förderrichtung automatisch freigegeben und nach einer Werkstückpassage sofort wieder vollständig geschlossen werden. Die beweglichen Teile der Absperrvorrichtungen können dabei aus ihrer Offenstellung von oben und/ oder auch von unten in die vertikale Schließstellung bewegt werden, wobei nur geringe Zeiten für die Bewegung der Absperrorgane erforderlich sind, so daß sowohl ein hochwirksamer Strahlungsschutz erreicht wird, als auch ein schleusenartiges Hindernis für die Strömung des Schutzgases aus der Bestrahlungskammer gebildet wird, d.h. die als Strahlungsschutz dienenden Absperrvorrichtungen bewirken auch eine starke Drosselung des Austritts von Schutzgas aus der Bestrahlungskammer, so daß der Verbrauch an Schutzgas stark reduziert ist.

Die oben bereits beschriebene vertikale Einstellbarkeit von Abschirmungen, die die Transportvorrichtung vor oder nach der Bestrahlungskammer gegen austretende Strahlung abdichten, ermöglicht auch einen einfachen Zugang zu der Transportvorrichtung für Wartungs- oder Reparaturzwecke. Die Abschirmungen können insgesamt (als zusammenhängende Baugruppe) auf jeder Seite der Bestrahlungskammer mittels einer geeigneten Hubvorrichtung angehoben werden. Auch durch die beschriebene Einstellbarkeit der Abschirmungen auf eine optimale Mindesthöhe, wird der Verbrauch von Schutzgas reduziert.

Nachfolgend sind Ausführungsbeispiele der Erfindung näher erläutert. Es zeigt:

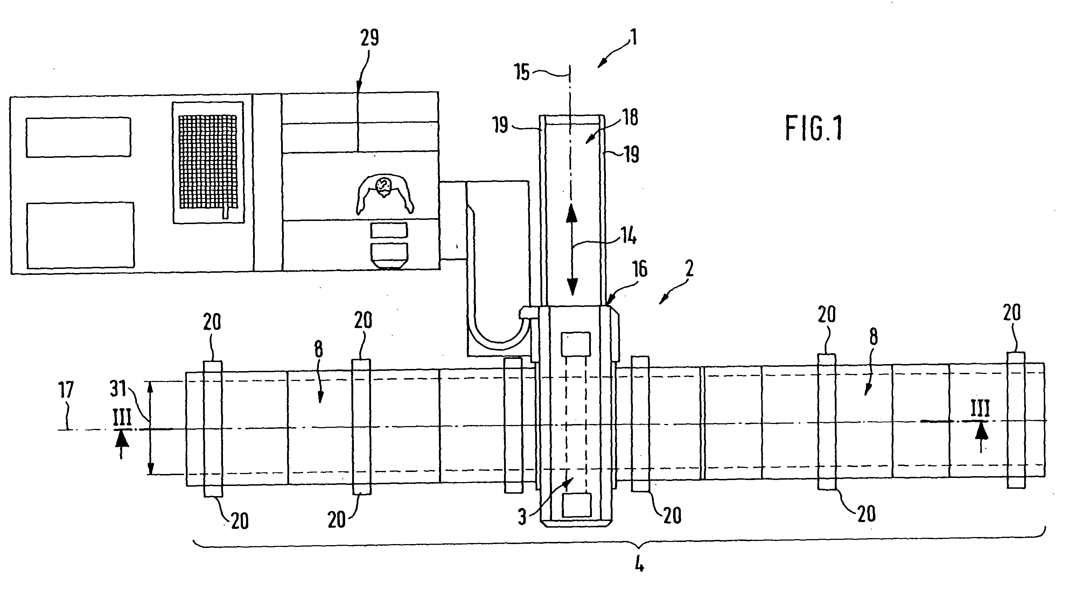

- Fig. 1: eine Draufsicht auf eine erfindungsgemäße Elektro nenstrahlanlage mit einer beidseits zugeordneten Transportvorrichtung und einer Steueranlage,

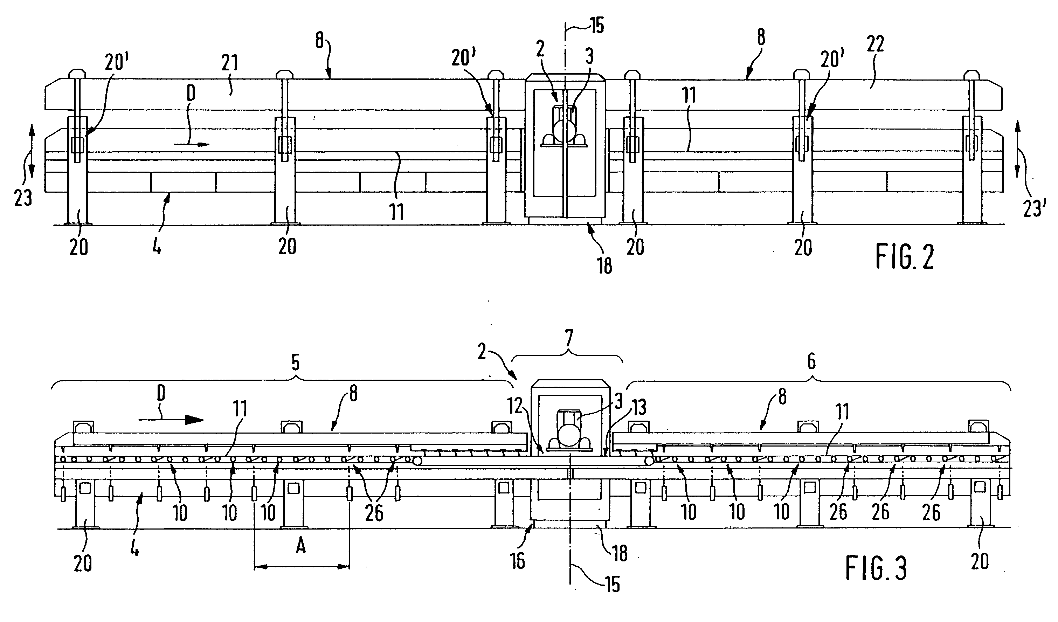

- Fig. 2: eine Seitenansicht der Elektronenstrahlanlage gemäß Fig. 1 mit einer oberhalb der Transportvorrichtung gelegenen Abschirmung in Öffnungsstellung,
- Fig. 3: eine geschnittene Seitenansicht der in geschlosse ner Arbeitsstellung befindlichen Elektronenstrahl anlage gemäß einer Linie III - III in Fig. 1,

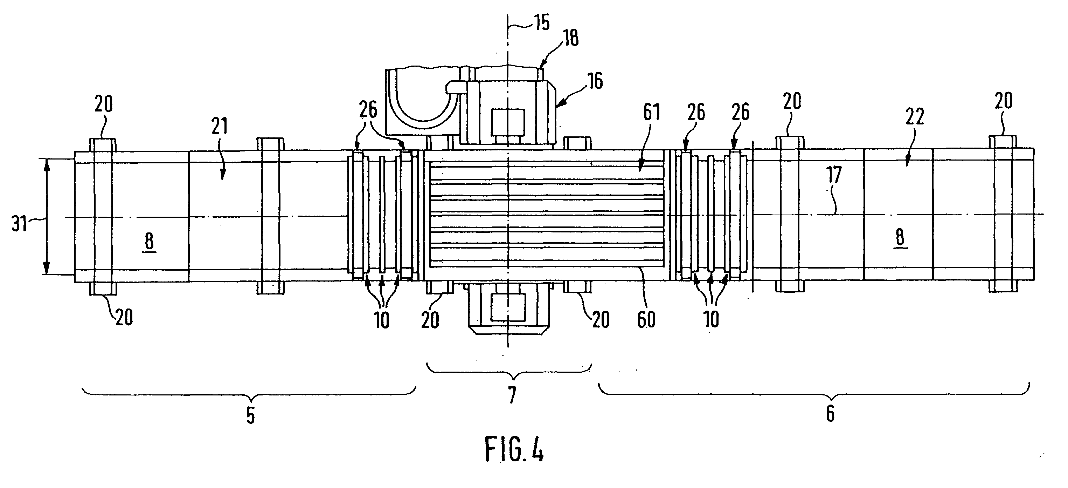

- Fig. 4: eine Draufsicht auf die Elektronenstrahlanlage mit einer teilweise geschnitten dargestellten Trans portvorrichtung im Bereich der Bearbeitungsstrecke,

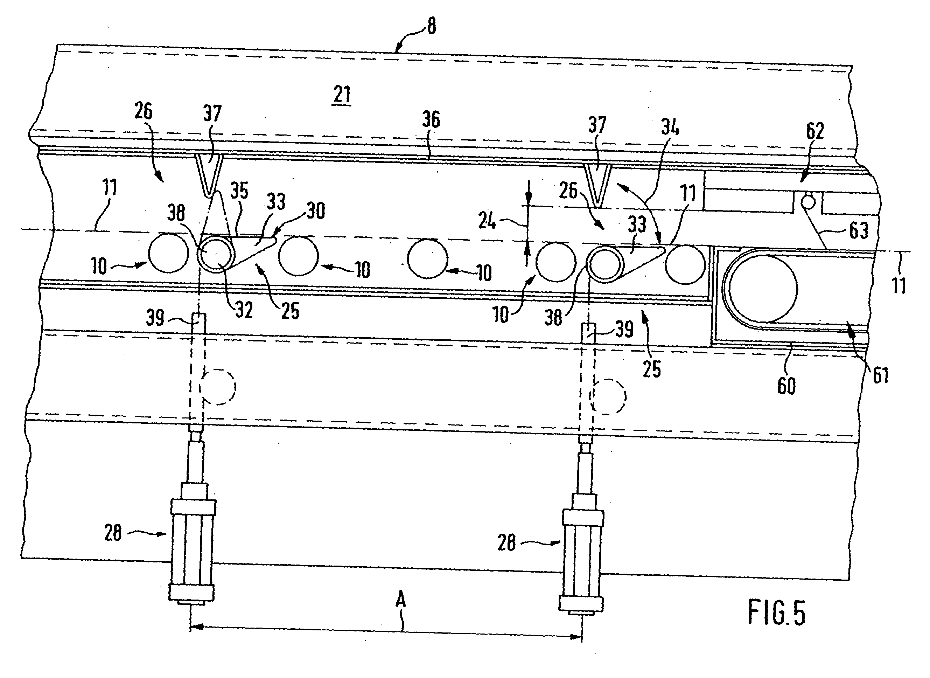

- Fig. 5: eine vergrößerte Ausschnittsdarstellung im Bereich der Transportvorrichtung mit einer unterhalb der Transportebene vorgesehenen Absperrvorrichtung in einer ersten Ausführungsform,

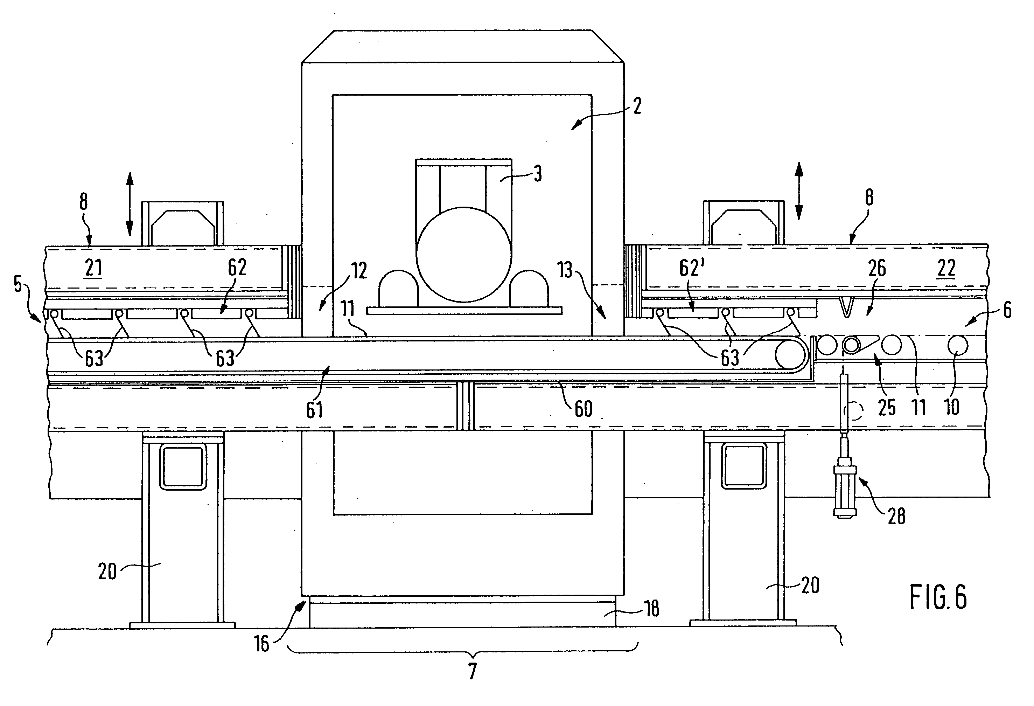

- Fig. 6: eine vergrößerte Ausschnittsdarstellung der Elek tronenstrahlanlage im Bereich der Bestrahlungskam mer und der Zu- und Abführstrecke der Transportvorrichtung,

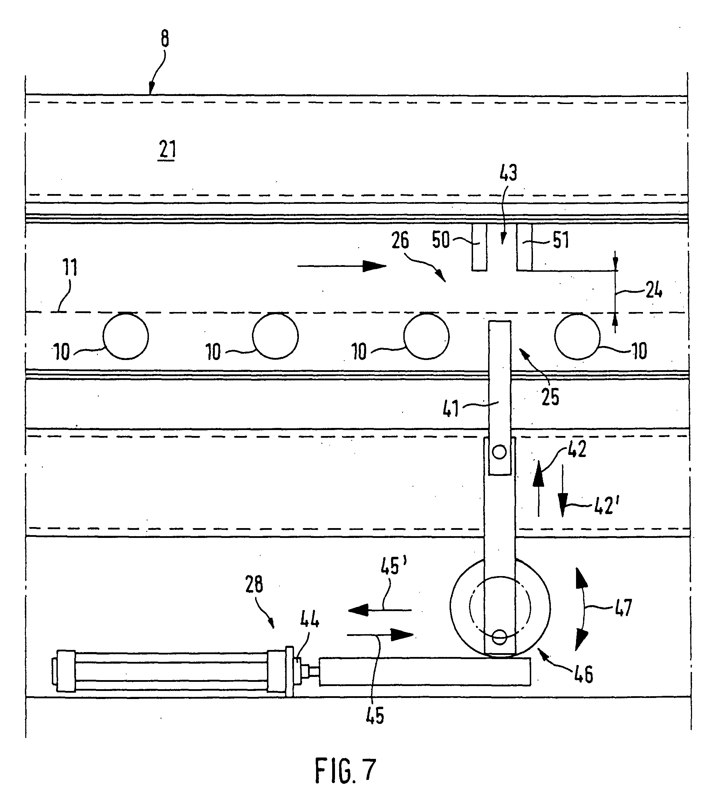

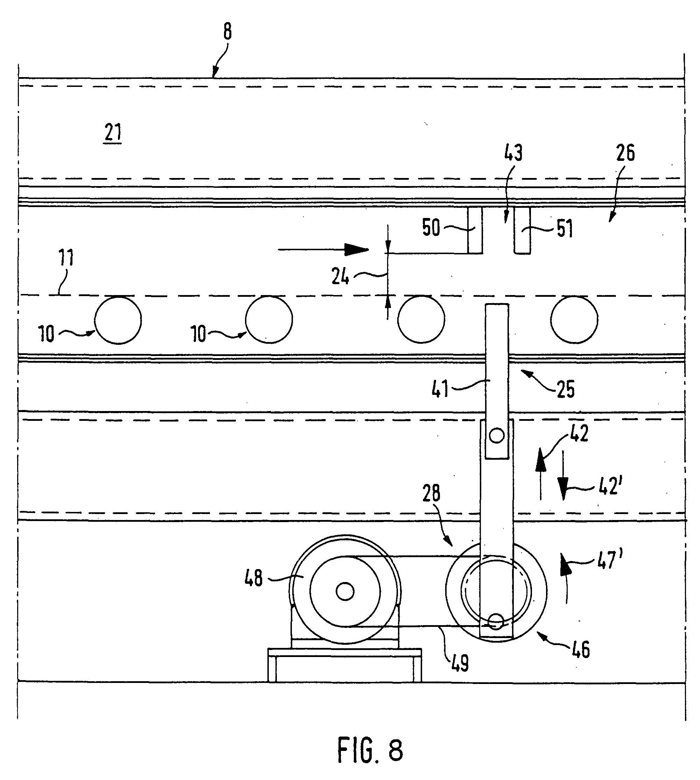

- Fig. 7 und Fig. 8: jeweils vergrößerte Einzeldarstellungen der Ab sperrvorrichtung in einer zweiten Ausführungsform mit einem Schubelement, und

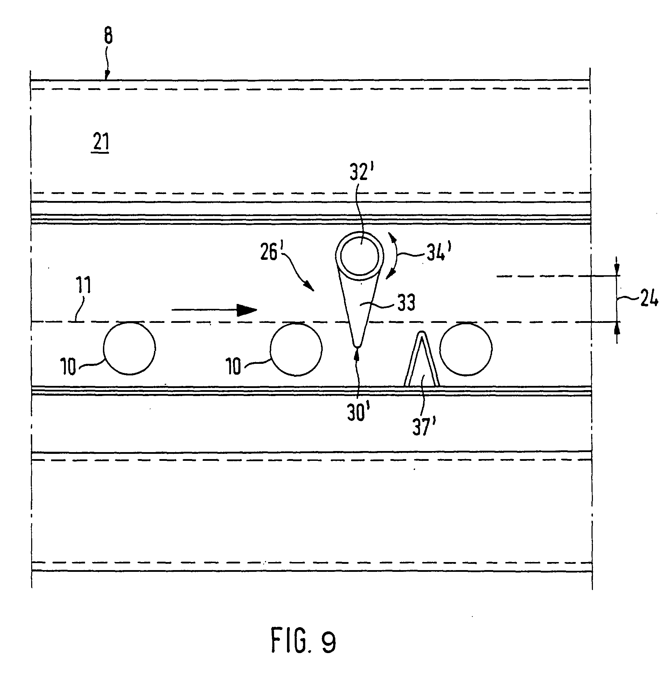

- Fig. 9: eine vergrößerte Einzeldarstellung der Absperrvor richtung in einer Ausführungsform ähnlich Fig. 5, wobei das Absperrorgan oberhalb der Transportbahn angeordnet ist.

In Fig. 1 ist eine insgesamt mit 1 bezeichnete Elektronenstrahlanlage in einer deren Gesamtaufbau verdeutlichenden Draufsicht gezeigt, wobei eine Bestrahlungskammer 2 mit einem Elektronenstrahlerzeuger 3 einer insgesamt mit 4 bezeichneten Transportvorrichtung zugeordnet ist. Die Transportvorrichtung 4 weist eine Zuführstrecke 5, eine Abführstrecke 6 und eine Bearbeitungsstrecke 7 (Fig. 3) auf und oberhalb dieser Teilstrecken ist die gesamte Transportvorrichtung 1 mit einer deren Einzelbauteile überdeckenden Abschirmung 8 versehen (Fig. 2).

Die Seitenansichten gemäß Fig. 2 und 3 verdeutlichen, daß die Transportvorrichtung 4 mittels ihrer Transportglieder 10 eine horizontale Transportbahn 11 definiert, auf der jeweilige plattenförmige Werkstücke (nicht dargestellt), insbesondere zum Aushärten von auf diesen befindlichen Kunststoffschichten, über eine Zuführöffnung 12 in die Bestrahlungskammer 2 eingeführt und über eine Abführöffnung 13 entnommen werden. Die Förderrichtung ist durch Pfeile D gezeigt.

Die erfindungsgemäße Elektronenstrahlanlage 1 ist in Fig. 1 in Arbeitsstellung dargestellt, wobei der im Bereich der Bestrahlungskammer 2 angeordnete Elektronenstrahlerzeuger 3 quer (Pfeil 14) zur Förderrichtung D entlang einer Mittellängsebene 15 an einem Tragwerk 16 so abgestützt ist, daß zumindest der Elektronenstrahlerzeuger 3 über eine Bewegung in Pfeilrichtung 14 aus der dargestellten Arbeitsstellung in eine allseitig zugängliche Wartungsstellung (nicht dargestellt) neben der Transportvorrichtung 4 verschiebbar ist. Mit dieser Verschiebemöglichkeit senkrecht zur Mittellängsebene 17 der Transportvorrichtung 4 ist insgesamt eine verbesserte Handhabung der Elektronenstrahlanlage 1 erreicht. Durch eine Abstützung des Tragwerks 16 auf einer Bodenplatte 18 mit entsprechenden Führungsteilen 19 (Fig. 1) ist es auch möglich, das gesamte Tragwerk 16 aus dem Bereich der Bearbeitungsstrecke 7 zu verschieben und damit Wartungs- und/ oder Umrüstarbeiten an der Anlage mit hoher Flexibilität und geringem Aufwand zu ermöglichen.

Die Abschirmungen 8 der Elektronenstrahlanlage 1 sind im Bereich der Zuführstrecke 5 bzw. der Abführstrecke 6 in vorteilhafter Ausführung jeweils in Form von Hubeinheiten 21 bzw. 22 ausgebildet. Eine Hubeinheit 21 bzw. 22 übergreift als einstückige Baugruppe die jeweilige Strecke der Transportvorrichtung 4. In der Darstellung gemäß Fig. 2 verdeutlichen Bewegungspfeile 23 und 23' die vertikalen Verstellmöglichkeiten der beiden Hubeinheiten 21, 22, wobei über eine entsprechende Steuerung von an Ständerteilen 20 abgestützten Huborganen 20' eine gleichzeitige oder unabhängige Verstellung dieser Abdeckungen 8 möglich ist.

In der Arbeitsstellung gemäß Fig. 3 sind die Hubeinheiten 21, 22 soweit abgesenkt, daß der oberhalb der Transportbahn 11 befindliche Durchlaßquerschnitt bzw. dessen Höhe 24 (Fig. 5) auf eine dichtungsoptimale Größe eingestellt werden kann, d.h. die Höhe 24 wird so klein als möglich eingestellt, so daß das Werkstück gerade durchpaßt. Mit dieser Verstellmöglichkeit ist die gesamte Elektronenstrahlanlage 1 überaus variabel und bei wechselnden Produkten mit geringem Aufwand an unterschiedliche Höhen der Werkstücke anpaßbar. In der abgesenkten Arbeitsstellung ist für ein in der Bestrahlungskammer 2 zur Inertisierung vorgesehenes Schutzgas die Möglichkeit eines Einweichens über die Zuführ- bzw. Abführöffnung 12, 13 und die Förderstrecken weitgehend gedrosselt und damit der Gasverbrauch der Anlage insgesamt gering.

Das Gesamtkonzept der Elektronenstrahlanlage 1 erfordert im Bereich der Zu- und Abführöffnung 12, 13 bzw. dem Durchlaßquerschnitt der Transportbahn 11 zusätzlich zu der Abschirmung 8 der Transportvorrichtung 4 eine als Streustrahlungsschutz vorgesehene Horizontalabschirmung (also eine auch in Horizontalrichtung wirksame Abschirmung), die von ein automatisch steuerbares Absperrorgan 25 aufweisenden Absperrvorrichtungen 26 (Fig. 5) gebildet wird.

Die Prinzipdarstellung gemäß Fig. 5 verdeutlicht dabei, daß die Absperrvorrichtungen 26 jeweils als im wesentlichen unterhalb der Transportbahn 11 angeordnete Baueinheiten vorgesehen sind und daß das Absperrorgan 25 aus seiner unterhalb der horizontalen Transportbahn 11 befindlichen Öffnungsstellung (Fig. 5, rechte Seite) in die senkrecht zur Transportbahn 11 verlaufende und den Durchlaßquerschnitt bzw. dessen Höhe 24 abdeckende Abschirmstellung (Fig. 5, linke Seite, Strichdarstellung des Absperrorgans 25) bewegbar ist. In zweckmäßiger Ausführung ist die Transportvorrichtung 4 sowohl im Bereich der Zuführstrecke 5 als auch der Abführstrecke 6 mit mehreren, jeweils mit 26 bezeichneten Absperrvorrichtungen versehen (Fig. 3), die in einem frei wählbaren Abstand A in Längsrichtung der Förderstrecken verteilt angeordnet sind.

Die Absperrvorrichtungen 26 bilden dabei insgesamt selbständig steuerbare Baueinheiten, deren Antrieb 28 jeweils mit einer Steuerzentrale 29 (Fig. 1) verbunden ist, mit der auch eine Steuerung der Bewegung des jeweiligen Absperrorgans 25, beispielsweise in Abhängigkeit von über entsprechende Lichtschrankensignale erfaßte Werkstückabmessungen oder dergleichen, möglich ist. Zur Bewegung der Absperrvorrichtung 26 bzw. des jeweiligen Absperrorgans 25 kann dabei ein elektrischer, hydraulischer oder pneumatischer Antrieb vorgesehen sein.

In der Ausführungsform des Absperrorgans 25 gemäß Fig. 5 ist dieses als eine in die Abschirmstellung bringbare Klappe 30 ausgebildet, die sich quer über die gesamte Breite 31 der Transportvorrichtung 4 (Fig. 4) erstreckt.

Die Klappe 30 ist mit einer sich parallel zu den als Rollenteile ausgebildeten Transportgliedern 10 unterhalb der Transportbahn 11 erstreckenden Querachse 32 versehen, an der einstückig ein als der unmittelbare Absperrteil wirksamer Profilflügel 33 ausgeformt ist, so daß die Absperrvorrichtung 26 bei Bewegungseinleitung nach Art einer Flügelklappe wirksam ist.

Die Seitenansicht gemäß Fig. 5 zeigt außerdem, daß die Klappe 30 nach einer Schwenkbewegung um ca. 90° (Pfeil 34) mit einer oberen Profilflanke 35 an einen oberhalb der Transportbahn 11 angeordneten und vorzugsweise an einem Deckelteil 36 der Hubeinheit 21 bzw. 22 abgestützten Anschlagflügel 37 anlegbar ist. Diese Schwenkbewegung wird der Klappe 30 dadurch vermittelt, daß im Bereich der Querachse 32 in einem exzentrischen Anlenkpunkt 38 der insbesondere als Hubzylinder mit einer Verbindungsstange 39 ausgebildete Antrieb 28 angreift. In der Öffnungsstellung (Fig. 5, rechte Seite) ist der Profilflügel 33 soweit verschwenkt, daß die Flügeloberseite 35 nahe der Transportbahn 11 verläuft. In zweckmäßiger Ausführung kann die Klappe 30 im Bereich des Flügels 33 mit einer Bleiblechverkleidung versehen werden, um die Abschirmungswirkung zu verbessern und ebenso ist denkbar, den Anschlagflügel 37 und/oder den Bereich der Flügeloberseite 35 mit einer Dämpfungsauflage zu versehen (nicht dargestellt), so daß nachteilige Geräuschbildungen bei Bewegung des Profilflügels 33 in die einen Dichtungseingriff bildende Schließstellung am Anschlagflügel 37 vermieden sind.

In Fig. 7 und 8 sind weitere Ausführungsformen der Absperrvorrichtung 26 dargestellt, wobei diese jeweils mit einem Absperrorgan 25 in Form einer vertikal beweglichen Platte 41 versehen sind. Die Platte 41 kann analog der schwenkbaren Flügelklappe 31 (gemäß Fig. 5) aus einer zwischen den Transportgliedern 10 befindlichen Öffnungsstellung (entspricht den Darstellungen in Fig. 7 und 8) über den eine Hubbewegung (Pfeil 42, 42') erzeugenden Antrieb 28 in eine oberhalb der Transportbahn 11 befindliche Aufnahmetasche 43 bewegt werden, so daß die Höhe 24 der entsprechenden Werkstückdurchlaßöffnung vollständig abgedeckt ist. In der Ausführungsform gemäß Fig. 9 ist der Antrieb 28 von einem waagerecht angeordneten Arbeitszylinder 44 gebildet, dessen Schub- und Zugbewegungen (Pfeile 45, 45') über eine Schwenkbewegung (Pfeil 47) über Kurbelteile 46 die vertikale Bewegung der Platte 41 bewirken. In der Ausführungsform gemäß Fig. 10 ist der Antrieb 28 von einem Stellmotor 48 gebildet, dessen Riementrieb 49 die Schwenk- oder Drehbewegung (Pfeil 47') der Kurbelteile 46 bewirkt, so daß die Platte 41 vertikal auf- und abwärts bewegbar ist.

In der Schließstellung (nicht dargestellt) greift die Platte 41 im Bereich der Aufnahmetasche 43 zwischen zwei im wesentlichen parallel ausgerichtete Plattenteile 50, 51 ein, deren Abschirmwirkung über einen zusätzlichen Bleibelag an der Aussenseite verbessert sein kann. Im Bereich der Innenseite kann die Aufnahmetasche 43 mit zusätzlichen Dichtungsteilen versehen sein, so daß die Aufnahmetasche 43 in Schließstellung in einem gasdichten Eingriff mit der Platte 41 bildet.

In Fig. 9 ist eine Absperrvorrichtung 26' in einer alternativen Ausführungsform zu den vorbeschriebenen Konstruktionen dargestellt, wobei diese Absperrvorrichtung 26' als eine oberhalb der Transportbahn 11 angeordnete Baueinheit ausgebildet ist, die mit entsprechenden Antriebsorganen (nicht dargestellt) so zusammenwirkt, daß die vorbeschriebenen Wirkungen als Horizontalabschirmung und Gasabdichtung über eine entsprechende Steuerung des Absperrorgans 25 erreicht werden.

In Fig. 6 ist der Übergangsbereich der Zu- und Abführöffnungen 12, 13 zu den entsprechenden Strecken 5, 6 der Transportvorrichtung 4 näher gezeigt, wobei eine vorteilhafte Ausbildung der Bearbeitungsstrecke 7 deutlich wird. Oberhalb einer Abbremswanne 60 ist eine Förderbahn 61 beidseits der Bestrahlungskammer 2 soweit verlängert, daß diese Förderbahn 61 bereichsweise unterhalb der Hubeinheit 21 bzw. 22 endet, also außerhalb der Bestrahlungskammer. In diesem Bereich sind jeweilige Strömungshindernisse 62, 62' vorgesehen, die in Arbeitsstellung bis in den Bereich der Transportbahn 11 reichen. Diese zur Abdichtung und/oder Drosselung des aus der Bestrahlungskammer 2 ausströmenden Schutzgases vorgesehenen Hindernisse 62, 62' bilden dabei mit jeweiligen schwenkbeweglichen Flügeln 63 eine zusätzliche Stauzone im Nahbereich zur Bestrahlungskammer 2, so daß damit auch bei hohem Gasdruck in der Bestrahlungskammer 2 der Schutzgasverbrauch der Elektronenstrahlanlage 1 insgesamt weiter gesenkt werden kann.

## Patentansprüche

1. Elektronenstrahlanlage zum Aushärten von insbesondere Kunststoffschichten auf Werkstücken, mit
- einer Bestrahlungskammer (2),
- einem Elektronenstrahlerzeuger (3) zum Erzeugen zumindest eines Elektronenstrahls in der Bestrahlungskammer (2),
- einer Transportvorrichtung (4) zum Fördern der Werkstücke in die Bestrahlungskammer (2) und aus der Bestrahlungskammer (2) heraus,
- wobei vor und nach der Bestrahlungskammer (2) jeweils zwei oder mehr Absperrvorrichtungen (26; 26') angeordnet sind, die in bezug auf die Transportvorrichtung (4) bewegbar und so unter Abstand in Förderrichtung der Transportvorrichtung (4) angeordnet sind, daß zumindest ein Werkstück zwischen zwei Absperrvorrichtungen (26; 26') paßt, und
- Abschirmungen (8), die die Transportvorrichtung (4) vor und nach der Bestrahlungskammer (2) von oben als Strahlungsschutz abdecken,
**dadurch gekennzeichnet, daß**
die Absperrvorrichtungen (26; 26') jeweils ein bewegbares Absperrorgan (25) aufweisen, das wahlweise in eine Offenstellung, in der es den Förderweg der Werkstücke auf der Transportvorrichtung freigibt, und in eine Schließstellung, in der es den Förderweg versperrt, bewegbar ist, und daß die Abschirmungen (8) in ihrer Höhe wahlweise einstellbar sind.

2. Elektronenstrahlanlage nach Anspruch 1,
**dadurch gekennzeichnet, daß**
in Förderrichtung (D) der Transportvorrichtung (4) vor der Bestrahlungskammer (2) mehr als zwei Absperrvorrichtungen (26; 26') angeordnet sind.

3. Elektronenstrahlanlage nach einem der Ansprüche 1 oder 2,
**dadurch gekennzeichnet, daß**
in Förderrichtung (D) der Transportvorrichtung (4) hinter der Bestrahlungskammer (2) mehr als zwei Absperrvorrichtungen (26; 26') angeordnet sind.

4. Elektronenstrahlanlage nach einem der vorhergehenden Ansprüche,
**dadurch gekennzeichnet, daß**
der Elektronenstrahlerzeuger (3) mittels eines ihn abstützenden Tragwerks (16) quer zur Förderrichtung (D) der Transportvorrichtung (4) aus der Bestrahlungskammer (2) in eine Stellung verschiebbar ist, in der er für Wartungs- und Reparaturarbeiten zugänglich ist.

5. Elektronenstrahlanlage nach einem der vorhergehenden Ansprüche,
**dadurch gekennzeichnet, daß**
die Transportvorrichtung (4) eine horizontale, im wesentlichen ebene Transportbahn für die Werkstücke vor, in und nach der Bestrahlungskammer (2) bildet.

## Claims

1. An electron-beam system for curing in particular plastic layers on workpieces, comprising
- an irradiation chamber (2);
- an electron gun (3) for generating at least one electron beam in the irradiation chamber (2);
- a transport device (4) for conveying the workpieces into the irradiation chamber (2) and out of the irradiation chamber (2);
- wherein in each case two or more blocking devices (26; 26') are arranged upstream and downstream of the irradiation chamber (2), which are movable relative to the transport device (4) and are arranged in the conveying direction of the transport device (4) at a spacing in such a manner that at least one workpiece fits between two blocking devices (26; 26;), and
- shields (8) which cover the transport device (4) from top as radiation protection upstream and downstream of the irradiation chamber (2),
**characterised in that**
the blocking devices (26; 26') each have a movable blocking element (25) which can optionally be moved into an open position in which it opens the conveying path of the workpieces on the transport device, and to a closing position in which it blocks the conveying path, and that the height of the shields (8) can optionally be set.

2. The electron-beam system according to claim 1,
**characterised in that** more than two blocking devices (26, 26') are arranged in the conveying direction (D) of the transport device (4) upstream of the irradiation chamber (2).

3. The electron-beam system according to one of claims 1 or 2,
**characterised in that** more than two blocking devices (26; 26') are arranged in the conveying direction (D) of the transport device (4) downstream of the irradiation chamber (2).

4. The electron-beam system according to one of the preceding claims,
**characterised in that** by means of a framework (16) supporting it the electron gun (3) can be moved transversely to the conveying direction (D) of the transport device (4) out of the irradiation chamber (2) to a position in which it is accessible for maintenance and repair work.

5. The electron-beam system according to one of the preceding claims,
**characterised in that** the transport device (4) forms a horizontal, essentially level transport track for the workpieces upstream of, in and downstream of the irradiation chamber (2).

## Revendications

1. Installation de bombardement électronique pour durcir en particulier des couches de matière synthétique sur des pièces, comprenant
- une chambre de bombardement (2),
- un canon électronique (3) pour générer au moins un faisceau électronique dans la chambre de bombardement (2),
- un dispositif de transport (4) pour amener les pièces dans la chambre de bombardement (2) et les sortir de la chambre de bombardement (2),
- deux ou plusieurs dispositifs de fermeture (26; 26') étant disposés respectivement avant et après la chambre de bombardement (2), lesquels sont mobiles par rapport au dispositif de transport (4) et sont disposés espacés dans la direction de transport du dispositif de transport (4) de telle façon qu'au moins une pièce puisse prendre place entre deux dispositifs de fermeture (26; 26') et
- des blindages (8) de protection radiologique qui recouvrent le dispositif de transport depuis le haut avant et après la chambre de bombardement (2),
**caractérisée en ce que**
les dispositifs de fermeture (26; 26') présentent chacun un organe de fermeture mobile (25) qui peut être déplacé au choix dans une position d'ouverture dans laquelle il libère le trajet de transport des pièces disposées sur le dispositif de transport et dans une position de fermeture dans laquelle il barre le trajet de transport et **en ce que** les blindages (8) sont réglable en hauteur à volonté.

2. Installation de bombardement électronique selon la revendication 1,
**caractérisée en ce que**
plus de deux dispositifs de fermeture (26; 26') sont disposés avant la chambre de bombardement (2) dans la direction de circulation (D) du dispositif de transport (4).

3. Installation de bombardement électronique selon la revendication 1 ou 2,
**caractérisée en ce que**
plus de deux dispositifs de fermeture (26; 26') sont disposés après la chambre de bombardement (2) dans la direction de circulation (D) du dispositif de transport (4).

4. Installation de bombardement électronique selon l'une quelconque des revendications précédentes,
**caractérisée en ce que**
le canon électronique (3) peut être déplacé au moyen d'un appareil porteur (16) le supportant transversalement par rapport à la direction de circulation (D) du dispositif de transport (4) hors de la chambre de bombardement (2) dans une position dans laquelle il est accessible pour des travaux d'entretien et de réparation.

5. Installation de bombardement électronique selon l'une quelconque des revendications précédentes,
**caractérisée en ce que**
le dispositif de transport (4) forme avant, dans et après la chambre de bombardement (2) une voie de transport horizontale, essentiellement plane pour les pièces.
